# EUROPEAN PATENT APPLICATION

(11) **EP 4 811 431 A1**
(43) Date of publication of application: **23.09.2026**
(21) Application number: 24891087.9
(22) Date of filing: 24.09.2024
(51) Int. Cl.: H01L 25/04, H01L 23/12, H01L 23/14, H01L 23/52

(54) **SEMICONDUCTOR PACKAGE, MODULE, AND METHOD FOR MANUFACTURING SEMICONDUCTOR PACKAGE**

(30) Priority: 16.11.2023 JP 2023194818
(71) Applicant: Sony Semiconductor Solutions Corporation, Atsugi-shi, Kanagawa 243-0014 (JP)
(72) Inventor: TAKAOKA, Yuji, Atsugi-shi, Kanagawa 243-0014 (JP); AMANO, Shigeki, Atsugi-shi, Kanagawa 243-0014 (JP)
(74) Representative: MFG Patentanwälte Meyer-Wildhagen Meggle-Freund Gerhard PartG mbB
(86) International application number: PCT/JP2024/033852
(87) International publication number: WO 2025/105045

(57) **Abstract**

The number of processes is reduced for a component in which a plurality of semiconductor chips is provided on a substrate.

A semiconductor package includes a silicon substrate, a plurality of semiconductor chips, an organic substrate, and an interconnect layer. In this semiconductor package, recesses are formed in the silicon substrate. Furthermore, in the semiconductor package, the plurality of semiconductor chips is arranged in each of the recesses. Moreover, in the semiconductor package, the interconnect layer is arranged between the organic substrate and the silicon substrate to electrically connect the plurality of semiconductor chips.

## Description

### TECHNICAL FIELD

The present technology relates to a semiconductor package. Specifically, the present technology relates to a semiconductor package provided with a plurality of semiconductor chips, a module, and a method for manufacturing a semiconductor package.

### BACKGROUND ART

In recent years, research and development of a multi-chip module (MCM) in which a plurality of semiconductor chips is mounted on a single substrate have been advancing. In this MCM, in a case where chips that require a large number of interconnects, such as high bandwidth memories (HBMs), are mounted, fine interconnects at the wafer process level need to be formed between the chips. Therefore, a semiconductor package having an interposer provided between a substrate and a semiconductor chip has been proposed (see, for example, Non-Patent Document 1).

### CITATION LIST

### NON-PATENT DOCUMENT

Non-Patent Document 1: Fukuda, Akira, "High-Performance Packaging Technology 'CoWoS' Evolved Through Five Generations Over a Decade (Part 1)", [online], published November 22, 2021, EE Times Japan, accessed October 26, 2023, Internet<URL: https://eetimes.itmedia.co.jp/ee/articles/2111/22/news031.html>

### SUMMARY OF THE INVENTION

### PROBLEMS TO BE SOLVED BY THE INVENTION

In the above-described conventional technology, a silicon (Si) interposer is provided between a substrate and a semiconductor chip to electrically connect chips. The above-described conventional technology, however, requires an organic interposer in addition to the Si interposer. Furthermore, in bonding and formation of the Si interposer and the semiconductor chip, the chip mounting surface needs to be embedded and planarized with a molding resin. In a case where the molding resin is embedded, when the total chip area is too small relative to the area of the interposer, warpage occurs, thereby requiring a dummy chip to be mounted. Accordingly, the number of processes increases due to the formation of through silicon vias (TSV) and the mounting of the dummy chip.

The present technology has been made in view of such circumstances, and it is therefore an object of the present technology to reduce the number of processes for a component in which a plurality of semiconductor chips is provided on a substrate.

### SOLUTIONS TO PROBLEMS

The present technology has been made to solve the above-described problems, and a first aspect thereof is a semiconductor package and a method for manufacturing the same, the semiconductor package including: a silicon substrate in which a recess is formed; a plurality of semiconductor chips arranged in the recess; an organic substrate; and an interconnect layer arranged between the organic substrate and the silicon substrate to electrically connect the plurality of semiconductor chips. This configuration eliminates the need for a Si interposer which has been used in conventional semiconductor packages, thereby reducing the number of manufacturing processes.

Furthermore, in the first aspect, the silicon substrate may include: a perforated member provided with openings; and a supporting substrate to which the perforated member is attached. This configuration eliminates the need for counterboring.

Furthermore, the first aspect may further include a molding resin embedded in the recess. This configuration reduces the amount of module resin.

Furthermore, a second aspect of the present technology is a module including: a silicon substrate in which a recess is formed; a plurality of semiconductor chips arranged in the recess; an organic substrate; and an interconnect layer arranged between the organic substrate and the silicon substrate to electrically connect the plurality of semiconductor chips. This configuration reduces the number of processes in module manufacturing.

### BRIEF DESCRIPTION OF DRAWINGS

Fig. 1 is a cross-sectional view illustrating a configuration example of a semiconductor package according to a first embodiment of the present technology.
Fig. 2 is a cross-sectional view illustrating a configuration example of a semiconductor package according to a comparative example.
Fig. 3 is a diagram for describing a series of processes up to the mounting of a semiconductor chip according to the first embodiment of the present technology.
Fig. 4 is a diagram for describing a series of processes up to the formation of bumps according to the first embodiment of the present technology.
Fig. 5 is a flowchart illustrating an example of a method for manufacturing the semiconductor package according to the first embodiment of the present technology.
Fig. 6 is a cross-sectional view illustrating a configuration example of a semiconductor package according to a second embodiment of the present technology.
Fig. 7 is a diagram for describing a series of processes up to the mounting of a semiconductor chip according to the second embodiment of the present technology.
Fig. 8 is a diagram for describing a series of processes up to the formation of bumps according to the second embodiment of the present technology.
Fig. 9 is a flowchart illustrating an example of a method for manufacturing the semiconductor package according to the second embodiment of the present technology.

### MODE FOR CARRYING OUT THE INVENTION

Modes for carrying out the present technology (hereinafter referred to as embodiments) will be described below. The description will be given in the following order.
1. First Embodiment (Example of Formation of Recess in Silicon Substrate by Counterboring)
2. Second Embodiment (Example of Formation of Recess by Bonding Wafers)

### <1. First Embodiment>

### [Configuration Example of Semiconductor Package]

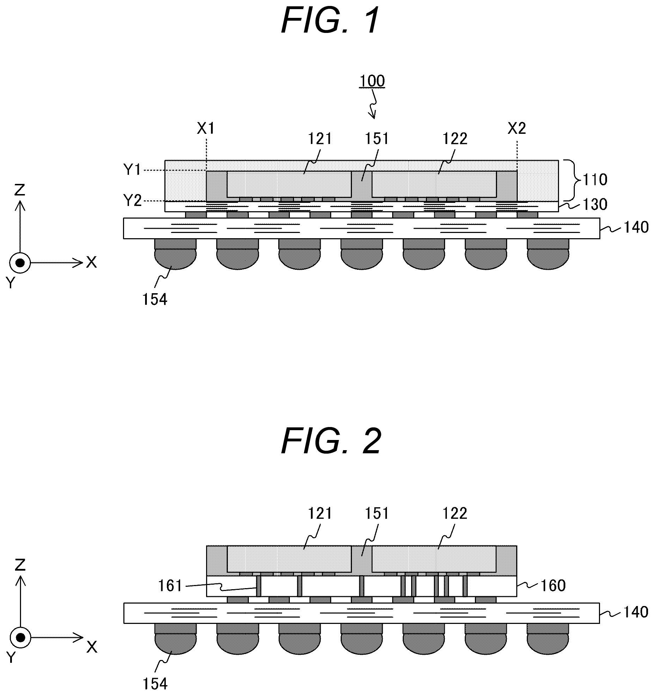

Fig. 1 is a cross-sectional view illustrating a configuration example of a semiconductor package 100 according to a first embodiment of the present technology. This semiconductor package 100 includes a silicon substrate 110, a plurality of chips such as semiconductor chips 121 and 122, an interconnect layer 130, and an organic substrate 140. The semiconductor package 100 can be provided in various semiconductor devices such as a smartphone and a digital still camera.

Note that a component having the structure illustrated in the drawing can also be referred to as a module. As illustrated in the drawing, a semiconductor package or module having a plurality of semiconductor chips provided on a single substrate is referred to as an HBM.

Hereinafter, a predetermined axis parallel to the substrate plane of the organic substrate 140 is defined as an "X-axis", and an axis orthogonal to the substrate plane is defined as a "Z-axis". Furthermore, an axis orthogonal to the X-axis and the Z-axis is defined as a "Y-axis". The drawing is a cross-sectional view when viewed from the Y-axis direction. Furthermore, in the Z-axis direction, a direction from the organic substrate 140 toward the silicon substrate 110 is defined as an "upward" direction.

In the lower surface of the silicon substrate 110, a recess extending upward is formed by counterboring. In the drawing, a portion surrounded by coordinates (X1, Y1), (X1, Y2), (X2, Y1), and (X2, Y2) corresponds to the recess.

In the recess in the silicon substrate 110, the plurality of semiconductor chips such as the semiconductor chips 121 and 122 is arranged, and a molding resin 151 is embedded. In this recess, various semiconductor chips, including memory chips such as HBMs and logic chips, can be arranged. Each chip is arranged such that its bumps face downward, and its upper surface is in contact with the bottom surface of the recess. Furthermore, a height from the bumps to the upper surface of each chip coincides with a depth of the recess (that is, the distance from Y1 to Y2).

The interconnect layer 130 is arranged between the silicon substrate 110 and the organic substrate 140. In the interconnect layer 130, inter-chip interconnects are formed to electrically connect the plurality of semiconductor chips. Furthermore, bumps are formed on the lower surface of the interconnect layer 130, thereby allowing flip-chip mounting on the upper surface of the organic substrate 140. On the lower surface of the organic substrate 140, a predetermined number of bumps 154 for connecting the semiconductor package 100 to an external component is formed.

Here, a configuration in which an interposer is arranged between the chips and the organic substrate 140 is assumed to be a comparative example.

Fig. 2 is a cross-sectional view illustrating a configuration example of a semiconductor package according to the comparative example. In this comparative example, an interposer 160 is arranged between the plurality of semiconductor chips and the organic substrate 140.

The interposer 160 electrically connects the plurality of semiconductor chips. Furthermore, bumps are formed on the lower surface of the interposer 160, thereby allowing flip-chip mounting on the upper surface of the organic substrate 140. For electrical connection of the bumps, a predetermined number of TSVs 161 is formed in the interposer 160.

Furthermore, the chips such as the semiconductor chips 121 and 122 are flip-chip mounted on the upper surface of the interposer 160. Furthermore, the molding resin 151 is embedded in a space between the chips.

In the comparative example, since the molding resin 151 is embedded in a space between the chips, when the total chip area is too small relative to (e.g., less than 80% of) the area of the interposer 160, the interposer 160 may become warped. In order to suppress this warpage, the comparative example requires a dummy chip to be mounted.

As described above, since the comparative example requires the TSVs 161 and the dummy chip, the number of manufacturing processes increases due to the process of forming the TSVs and the process of mounting the dummy chip.

On the other hand, as illustrated in Fig. 1, in a case where recesses are formed in the silicon substrate 110 and a plurality of semiconductor chips is arranged in each of the recesses, the chips can be connected by interconnects in the interconnect layer 130 formed at the wafer process level. This configuration eliminates the need for the interposer 160. Furthermore, since the molding resin 151 is embedded in the recess, the amount of the molding resin 151 can be reduced compared with the comparative example to suppress the effects of warpage. This configuration eliminates the need for the dummy chip. Since neither the interposer 160 nor the dummy chip is required, the number of processes can be significantly reduced compared with the comparative example. This reduction in the number of processes allows a reduction in manufacturing costs compared with the comparative example.

### [Method for Manufacturing Semiconductor Package]

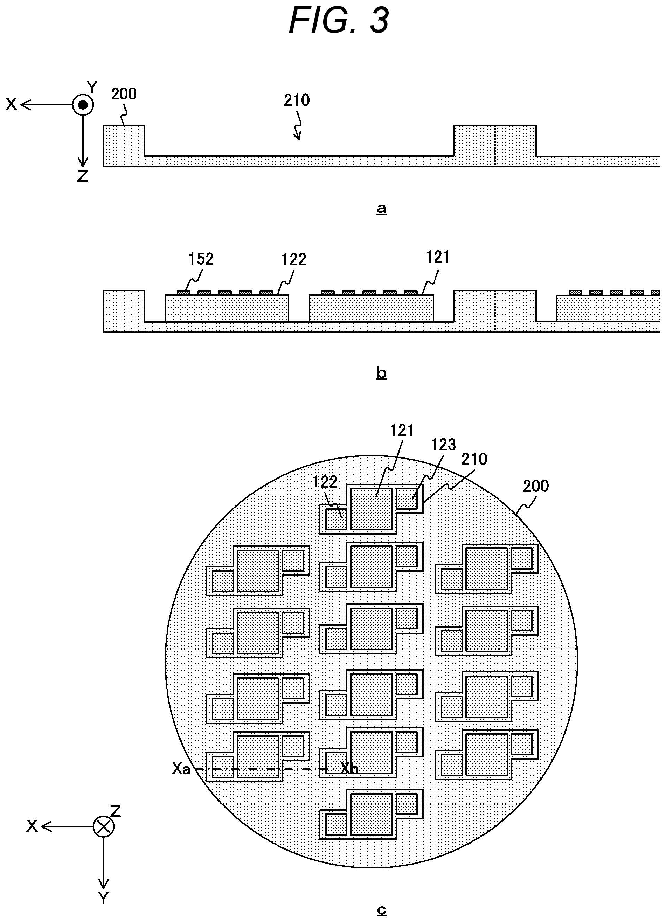

Next, a method for manufacturing the semiconductor package 100 according to the first embodiment will be described with reference to Figs. 3 to 5.

First, as illustrated in a of Fig. 3, a predetermined number of recesses 210 is formed in a silicon wafer 200 by counterboring. A dotted line in a and the subsequent drawings indicates a portion to be cut in a dicing process described later. Then, a plurality of chips such as the semiconductor chips 121 and 122 is arranged in each of the recesses 210 such that bumps 152 face upward.

In the drawing, c is an example of a plan view of the silicon wafer 200 in the process illustrated in b of the drawing. A plurality of recesses is formed in the circular silicon wafer 200, and the semiconductor chips 121, 122, and 123 are arranged in each of the recesses. In the drawing, b corresponds to a cross-sectional view taken along line segment Xa-Xb in c of the drawing.

Note that the recesses have a depth of, for example, 500 micrometers (µm), which is equal to the height of the chips. However, in a case where the height of the chips is greater than the depth of the recesses, it is only required to stack two silicon wafers, for example. In this case, recesses are formed in the first silicon wafer, and openings having the same shape as the recesses as viewed from the Z direction are provided in the second silicon wafer.

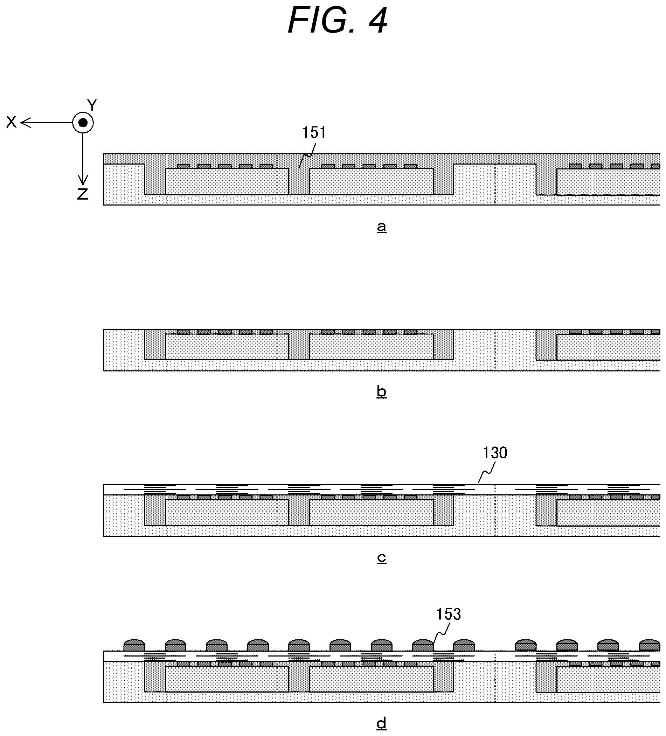

Next, as illustrated in a of Fig. 4, the molding resin 151 is embedded in the recesses, and as illustrated in b of Fig. 4, the molding resin 151 is polished and planarized until the bumps are exposed.

Then, as illustrated in c of the drawing, the chips are interconnected at the wafer process level, thereby forming the interconnect layer 130. Since fine interconnects are provided at the wafer process level, the interposer 160 is not required even in a case where a chip requiring a large number of interconnects, such as an HBM, is used.

Then, as illustrated in d in the drawing, a predetermined number of bumps 153 is formed on the interconnect layer 130. Then, the silicon wafer is diced into a plurality of silicon substrates 110, and each silicon substrate 110 is flip-chip mounted on the organic substrate 140.

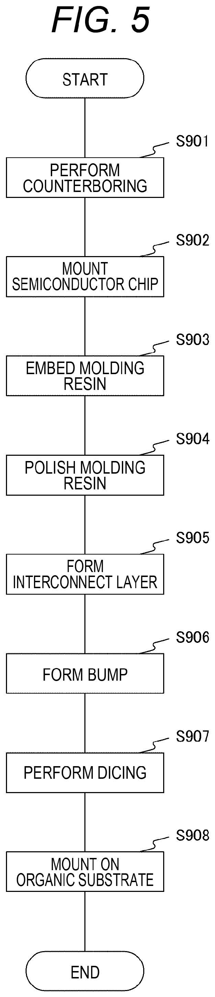

Fig. 5 is a flowchart illustrating an example of the method for manufacturing the semiconductor package 100 according to the first embodiment of the present technology.

A predetermined number of recesses is formed in the silicon wafer 200 by counterboring (step S901), and a plurality of semiconductor chips is mounted in each of the recesses (step S902). Then, the molding resin 151 is embedded in the recesses (step S903), and the molding resin 151 is polished until the bumps are exposed (step S904). Then, the interconnect layer 130 is formed at the wafer process level (step S905), and the predetermined number of bumps 153 is formed on the interconnect layer 130 (step S906).

Then, the silicon wafer is diced into a plurality of silicon substrates 110 (step S907), and each silicon substrate 110 is flip-chip mounted on the organic substrate 140 (step S908). After step S908, various processes are performed, thereby completing the manufacturing process of the semiconductor package 100.

As described above, according to the first embodiment of the present technology, since the plurality of semiconductor chips is arranged in each of the recesses provided in the silicon substrate 110, neither the interposer 160 nor the dummy chip is required, thereby allowing a reduction in the number of processes. As a result, manufacturing costs can be reduced.

### <2. Second Embodiment>

In the first embodiment described above, the recesses are formed in the silicon substrate 110 by counterboring, but the present disclosure is not limited to this manufacturing method. A method for manufacturing a semiconductor package 100 according to a second embodiment described below is different from that of the first embodiment in that the recesses are formed by bonding wafers.

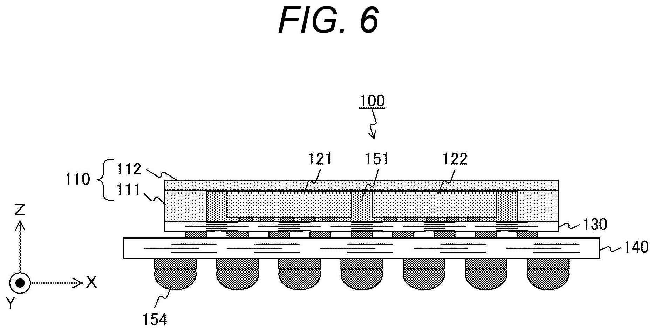

Fig. 6 is a cross-sectional view illustrating a configuration example of the semiconductor package 100 according to the second embodiment of the present technology. The semiconductor package 100 according to the second embodiment described below is different from that of the first embodiment in that the silicon substrate 110 includes a supporting substrate 112 and a perforated member 111.

An opening is formed in the perforated member 111, and the supporting substrate 112 is attached to the upper surface of the perforated member 111. A space surrounded by the opening of the perforated member 111 and the supporting substrate 112 corresponds to the recess of the silicon substrate 110, and a plurality of semiconductor chips is arranged in the recess.

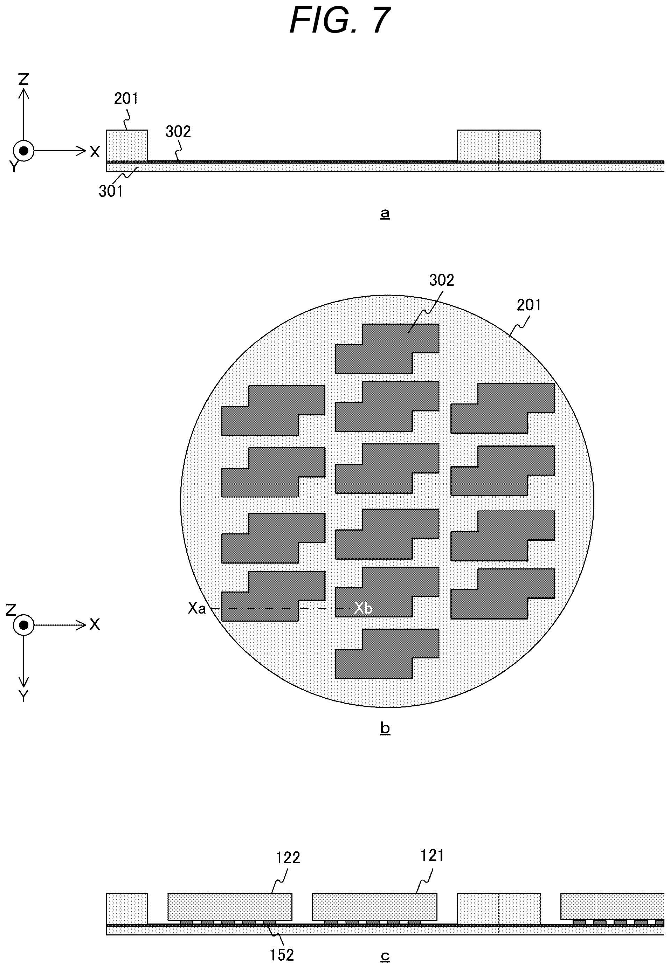

Next, the method for manufacturing the semiconductor package 100 according to the second embodiment will be described with reference to Figs. 7 to 9.

As illustrated in a of Fig. 7, a bonding tape 302 is attached to the upper surface of a support wafer 301, and a silicon-based perforated wafer 201 is pressure-bonded by ultraviolet (UV) bonding or thermal bonding. As the support wafer 301, a silicon wafer or a glass wafer can be used.

In the drawing, b is an example of a plan view of the perforated wafer 201 in the process illustrated in a of the drawing. As illustrated in the drawing, a plurality of openings is formed in the circular perforated wafer 201, and the bonding tape 302 located at the lower side is exposed through each opening.

Then, as illustrated in c of the drawing, a plurality of chips such as the semiconductor chips 121 and 122 is arranged in the openings such that their bumps 152 face downward.

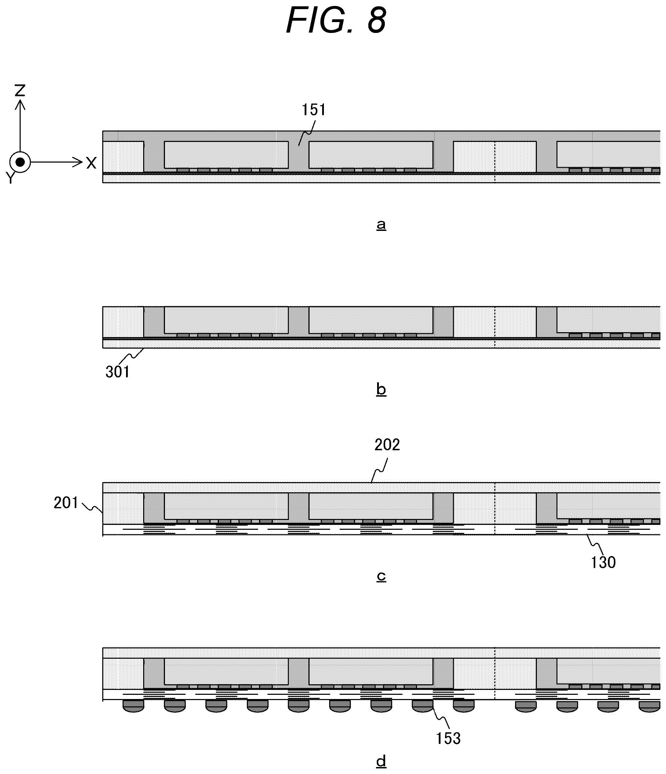

Next, as illustrated in a of Fig. 8, the molding resin 151 is embedded in the openings. Then, as illustrated in b of the drawing, the molding resin 151 is polished and planarized until the upper surface of each semiconductor chip is exposed.

Then, the support wafer 301 is removed, and a silicon-based supporting wafer 202 is attached to the upper surface of the perforated wafer 201 with an adhesive or the like. As a result, the recesses are formed.

Then, as illustrated in c of the drawing, the interconnect layer 130 is formed on the bump side of each semiconductor chip at the wafer process level. In practice, the process illustrated in c of the drawing is performed with the wafer flipped over.

Then, as illustrated in d in the drawing, a predetermined number of bumps 153 is formed on the interconnect layer 130. Then, the silicon wafer including the perforated wafer 201 and the supporting wafer 202 is diced into a plurality of silicon substrates 110, and each silicon substrate 110 is flip-chip mounted on the organic substrate 140.

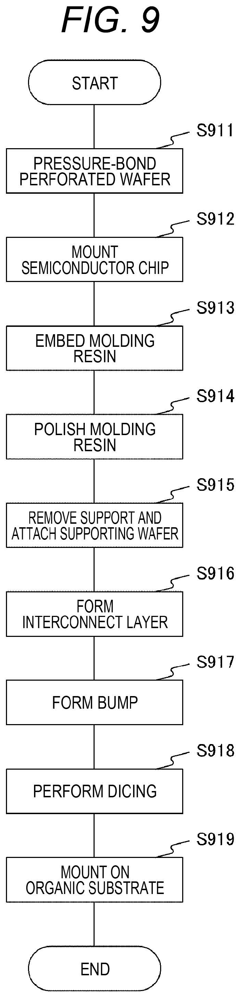

Fig. 9 is a flowchart illustrating an example of the method for manufacturing the semiconductor package 100 according to the second embodiment of the present technology.

The perforated wafer 201 is pressure-bonded to the upper surface of the support wafer 301 (step S911), and a plurality of semiconductor chips is mounted in the openings (step S912). Then, the molding resin 151 is embedded in the openings (step S913), and the molding resin 151 is then polished (step S914). Then, the support wafer 301 is removed, and the silicon-based supporting wafer 202 is attached to the upper surface of the perforated wafer 201 with an adhesive or the like (step S915).

Then, the interconnect layer 130 is formed at the wafer process level (step S916), and the predetermined number of bumps 153 is formed on the interconnect layer 130 (step S917). Then, the silicon wafer is diced into a plurality of silicon substrates 110 (step S918), and each silicon substrate 110 is flip-chip mounted on the organic substrate 140 (step S919). After step S919, various processes are performed, thereby completing the manufacturing process of the semiconductor package 100.

As described above, according to the second embodiment of the present technology, the recesses are formed by attaching the silicon-based supporting wafer 202 to the perforated wafer 201, thereby eliminating the need for counterboring.

Note that the embodiments have been described as examples for embodying the present technology, and the matters in the embodiments and the matters defining the invention in the claims have correspondence relationships. Similarly, the matters defining the invention in the claims and the matters with the same names in the embodiments of the present technology have correspondence relationships. The present technology, however, is not limited to the embodiments, and can be embodied by applying various modifications to the embodiments without departing from the scope of the present technology.

Note that the effects described herein are merely examples and are not intended to be limiting, and other effects may also be achieved.

Note that the present technology may also have the following configurations.
(1) A semiconductor package including:
   a silicon substrate in which a recess is formed;
   a plurality of semiconductor chips arranged in the recess;
   an organic substrate; and
   an interconnect layer arranged between the organic substrate and the silicon substrate to electrically connect the plurality of semiconductor chips.
(2) The semiconductor package according to the above (1), in which
   the silicon substrate includes:
   a perforated member provided with openings; and
   a supporting substrate to which the perforated member is attached.
(3) The semiconductor package according to the above (1) or (2), further including:
   a molding resin embedded in the recess.
(4) A module including:
   a silicon substrate in which a recess is formed;
   a plurality of semiconductor chips arranged in the recess;
   an organic substrate; and
   an interconnect layer arranged between the organic substrate and the silicon substrate to electrically connect the plurality of semiconductor chips.
(5) A method for manufacturing a semiconductor package, the method including:
   forming a recess in a silicon wafer;
   arranging a plurality of semiconductor chips in the recess;
   forming an interconnect layer that electrically connects the plurality of semiconductor chips;
   singulating the silicon wafer into a predetermined number of silicon substrates; and
   mounting the silicon substrates on an organic substrate.
(6) A method for manufacturing a semiconductor package, the method including:
   pressure-bonding a predetermined surface of a perforated wafer provided with openings to a support wafer;
   arranging a plurality of semiconductor chips in the openings;
   removing the support wafer and attaching a supporting wafer to a surface opposite to the predetermined surface of the perforated wafer;
   forming an interconnect layer that electrically connects the plurality of semiconductor chips;
   singulating the perforated wafer and the supporting wafer into a predetermined number of silicon substrates; and
   mounting the silicon substrates on an organic substrate.

### REFERENCE SIGNS LIST

- 100: Semiconductor package
- 110: Silicon substrate
- 111: Perforated member
- 112: Supporting substrate
- 121, 122: Semiconductor chip
- 130: Interconnect layer
- 140: Organic substrate
- 151: Molding resin
- 152 to 154: Bump
- 160: Interposer
- 161: TSV
- 200: Silicon wafer
- 201: Perforated wafer
- 202: Supporting wafer
- 210: Recess
- 301: Support wafer
- 302: Bonding tape

## Claims

1. A semiconductor package comprising:
a silicon substrate in which a recess is formed;
a plurality of semiconductor chips arranged in the recess;
an organic substrate; and
an interconnect layer arranged between the organic substrate and the silicon substrate to electrically connect the plurality of semiconductor chips.

2. The semiconductor package according to claim 1, wherein
the silicon substrate includes:
a perforated member provided with openings; and
a supporting substrate to which the perforated member is attached.

3. The semiconductor package according to claim 1, further comprising:
a molding resin embedded in the recess.

4. A module comprising:
a silicon substrate in which a recess is formed;
a plurality of semiconductor chips arranged in the recess;
an organic substrate; and
an interconnect layer arranged between the organic substrate and the silicon substrate to electrically connect the plurality of semiconductor chips.

5. A method for manufacturing a semiconductor package, the method comprising:
forming a recess in a silicon wafer;
arranging a plurality of semiconductor chips in the recess;
forming an interconnect layer that electrically connects the plurality of semiconductor chips;
singulating the silicon wafer into a predetermined number of silicon substrates; and
mounting the silicon substrates on an organic substrate.

6. A method for manufacturing a semiconductor package, the method comprising:
pressure-bonding a predetermined surface of a perforated wafer provided with openings to a support wafer;
arranging a plurality of semiconductor chips in the openings;
removing the support wafer and attaching a supporting wafer to a surface opposite to the predetermined surface of the perforated wafer;
forming an interconnect layer that electrically connects the plurality of semiconductor chips;
singulating the perforated wafer and the supporting wafer into a predetermined number of silicon substrates; and
mounting the silicon substrates on an organic substrate.
